# DEMANDE DE BREVET EUROPEEN

(11) **EP 4 517 837 A1**
(43) Date de publication de la demande: **05.03.2025**
(21) Numéro de dépôt: 23193763.2
(22) Date de dépôt: 28.08.2023
(51) Int. Cl.: H01L 31/0224, H01L 31/0468, H01L 31/048

(54) **CELLULE PHOTOVOLTAÏQUE À AGENCEMENT SPÉCIFIQUE DE COLLECTEURS D'ÉNERGIE, ET PROCÉDÉ DE RÉALISATION D'UNE TELLE CELLULE**

(71) Demandeur: ETA SA Manufacture Horlogère Suisse, 2540 Grenchen (CH)
(72) Inventeur: KLOPFENSTEIN, François, 2800 Delémont (CH); GUEISSAZ, François, 2036 Cormondrèche (CH); DIDIER, Alexandre, 3235 Erlach (CH)
(74) Mandataire: ICB SA

(57) **Abrégé**

La présente invention concerne une cellule photovoltaïque (1). La cellule photovoltaïque (1) comprend une première couche de collecteur frontal (4), une couche de silicium amorphe (6) sur la première couche (4) et une seconde couche conductrice (8) sur la couche de silicium amorphe (6). Une connexion électrique de la seconde couche conductrice (8) à la première couche (4) est réalisée à travers la couche de silicium amorphe (6). La connexion électrique de la seconde couche conductrice (8) à la première couche (4) est réalisée à travers la couche de silicium amorphe (6) en périphérie de la cellule photovoltaïque, en ce que la couche conductrice d'électricité (8) comprend un bus périphérique positif (8'), qui est relié à la première couche TCO (4) et à au moins une borne de connexion positive à une extrémité du bus périphérique positif, et un bus périphérique négatif, qui est relié à une borne de connexion négative, et en ce que les bus périphériques positif et négatif sont asymétriques l'un par rapport à l'autre, avec le bus périphérique positif de plus grande longueur que le bus périphérique négatif.

## Description

### Domaine technique de l'invention

L'invention se rapporte à une cellule photovoltaïque à agencement spécifique de collecteurs d'énergie sous forme de courant électrique, ainsi qu'au procédé de réalisation d'une telle cellule photovoltaïque.

La présente invention consiste donc à optimiser le rendement d'une cellule photovoltaïque de manière à être utilisée dans un objet portable électronique, tel qu'une montre-bracelet.

### Arrière-plan technologique

Chaque cellule photovoltaïque est réalisée d'une forme générale adaptée à la forme de l'objet portable la recevant. Généralement, il peut s'agir d'une cellule de forme cylindrique circulaire disposée soit sur une surface intérieure du verre de l'objet portable la recevant, soit sur une surface du cadran visible de l'extérieur de l'objet portable.

Une telle cellule photovoltaïque est réalisée au moyen d'un ensemble de couches, notamment une première couche frontale transparente à la lumière ambiante, appelée collecteur frontal, qui peut être réalisée au moyen d'une couche d'oxyde de zinc dopée avec de l'aluminium (ZnO:AI ou AZO). Cette première couche peut être disposée sur la surface intérieure du verre de l'objet portable en regard du cadran et sur laquelle est généralement déposée une séquence de type p-i-n (dopage p, intrinsèque i, dopage n) de couches minces de silicium amorphe (a-Si), nommée absorbeur, qui convertit le rayonnement lumineux absorbé en porteurs de charge électrique positive (trous) et négative (électrons). La structure se termine généralement par une deuxième couche conductrice, par exemple de l'aluminium ou autre combinaison de métaux, appelée collecteur arrière.

Dans cette configuration, les porteurs de charge positive dérivent vers le collecteur frontal où ils sont neutralisés par les électrons provenant d'un circuit électrique externe. Les porteurs de charge négative dérivent eux vers le collecteur arrière où ils alimentent le circuit externe en électrons et forment le courant de charges négatives entre le collecteur arrière et le collecteur frontal. Selon la convention, on parle d'un courant électrique (positif) qui circule entre le pôle positif et le pôle négatif, le courant de charges est donc bien négatif dans la configuration qui vient d'être décrite.

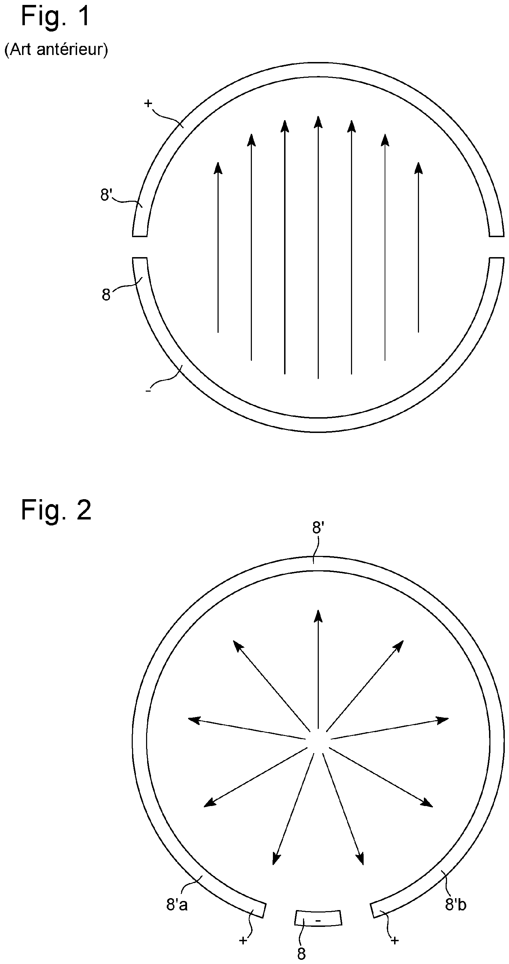

Initialement, pour une technologie n'utilisant qu'un seul niveau de métal, une forme d'exécution comme représentée à la figure 1 a été proposée pour la réalisation de la cellule photovoltaïque, selon l'art antérieur. Dans cette forme d'exécution, on remarque que les collecteurs de courant ou bus périphériques sont proposés selon un design symétrique, c'est-à-dire avec les bus périphériques de longueurs, largeurs et épaisseurs plus ou moins identiques et formant deux demis anneaux ou arcs de cercle à la circonférence de la cellule de forme circulaire. De manière générale, les bus doivent être le plus long possible, de manière à favoriser une répartition la plus homogène possible du courant électrique dans le collecteur frontal de la cellule photovoltaïque, ce qui permet de réduire les pertes résistives.

Dans le cas d'une cellule photovoltaïque homogène, dite à mono segment, selon la figure 1, on constate que les lignes de courant suivent un parcours approximativement rectiligne et parallèle entre les deux bus périphériques. Dans l'état actuel de la technologie des couches transparentes conductrices, utilisées pour constituer le collecteur frontal, on note que la résistance de couche est supérieure au minimum d'un à deux ordres de grandeurs à celle de la couche mince déposée à l'arrière de la cellule, pour constituer le collecteur arrière.

Il résulte de cette différence de résistance de couche un gradient de potentiel considérablement plus élevé au sein du collecteur frontal qu'en celui du collecteur arrière lorsqu'un courant électrique les traverse, ainsi qu'une perte de puissance qui croît lorsque la valeur du courant électrique augmente.

### Résumé de l'invention

La présente invention propose donc une cellule photovoltaïque avec un agencement spécifique des collecteurs de courant ou bus périphériques qui réduit de manière substantielle la chute de tension au sein du collecteur frontal, induite par le courant électrique généré par la couche d'absorption suite à la captation de la lumière.

À cet effet, la présente invention concerne une cellule photovoltaïque agencée pour réduire de manière substantielle la chute de tension au sein du collecteur frontal, comme définie dans la revendication indépendante 1.

Des formes d'exécution particulières de la cellule photovoltaïque sont définies dans les revendications dépendantes 2 à 8.

Afin d'assurer les contacts électriques d'un seul côté d'une cellule photovoltaïque, on sépare généralement, par gravure chimique ou autre méthode, une portion du collecteur arrière afin de l'utiliser comme terminal positif. Ce terminal positif est électriquement connecté au collecteur frontal grâce à un bus métallique déposé dans une ouverture pratiquée au préalable au travers de la séquence de couches minces de silicium amorphe (absorbeur). Le collecteur frontal, transparent et conducteur (TCO) qui peut être réalisé au moyen d'une couche d'oxyde de zinc dopée avec de l'aluminium (ZnO:AI ou AZO), est d'une conductivité bien moins bonne que celle du collecteur arrière, qui peut être une couche métallique par exemple en aluminium. Cette différence de conductivité est de l'ordre de 30 fois moins bonne.

Dans ces conditions selon la présente invention, il est prévu au moins un bus périphérique métallique relié au collecteur frontal, qui est d'une longueur bien plus grande que la longueur du bus périphérique métallique ménagé dans le collecteur arrière. De préférence, la longueur du bus périphérique frontal doit être au moins 10 fois supérieure à la longueur du bus périphérique arrière. Cette asymétrie en longueur entre les bus périphériques, qui ont par exemple une même largeur et une même épaisseur, permet de limiter ou réduire la chute de potentiel au sein du collecteur frontal à moins de 100 mV. Ceci représente un gain de près de 50 mV par rapport à une chute de potentiel observée dans une cellule photovoltaïque à bus périphériques symétriques. La chute de potentiel au sein du collecteur frontal peut être inférieure à 100 mV, ce qui permet de limiter la perte de puissance avec une cellule photovoltaïque qui développe une tension ne dépassant pas 600 à 700 mV avant traitement dans un module électronique d'un objet portable.

Avantageusement, depuis la connexion du collecteur frontal à une portion du collecteur arrière, qui est de préférence la couche métallique en aluminium sur une face opposée, il peut être prévu de réaliser deux bus de longueurs asymétriques reliant d'une part le collecteur frontal, et d'autre celle reliant la couche métallique en aluminium définissant le terminal négatif ou borne négative.

De plus, il s'avère que l'on peut également depuis le point de connexion de la couche d'aluminium au collecteur frontal prévoir deux portions de bus périphériques en liaison au terminal positif décrivant un angle défini de part et d'autre du point de connexion au collecteur frontal. L'angle décrit par le bus périphérique du collecteur frontal positif est beaucoup plus grand que l'angle du terminal négatif de la couche d'aluminium. On peut s'attendre à une couverture du bus périphérique connecté au collecteur frontal défini sur 330°, alors que la portion de terminal négatif de la couche d'aluminium peut être inférieure à 30° d'angle.

Avantageusement, chaque extrémité libre du bus périphérique positif connecté au collecteur frontal comprend une extrémité de connexion de manière à réduire encore le courant parcourant ce bus périphérique métallique. Ainsi, les deux bornes positives liées à ce bus périphérique connecté au collecteur frontal sont destinées à être connectées en parallèle par un connecteur flexible par exemple à un module électronique de traitement des données. La valeur du courant électrique circulant vers chacune des extrémités du bus périphérique métallique vaut ainsi la moitié de celle du courant total entrant vers le terminal négatif. Cela signifie encore qu'il est prévu deux bornes d'extrémité positive et une borne d'extrémité négative à connecter au module électronique disposé principalement sous le cadran de l'objet portable.

À cet effet, la présente invention concerne également un procédé de réalisation d'une cellule photovoltaïque, comme définie dans la revendication indépendante 9.

### Brève description des figures

Les buts, avantages et caractéristiques d'une cellule photovoltaïque à agencement spécifique de collecteurs d'énergie, ainsi que ceux d'un procédé de réalisation d'une telle cellule photovoltaïque apparaîtront mieux dans la description suivante de manière non limitative en regard des dessins sur lesquels :
- la figure 1 représente une vue de dessous de la cellule photovoltaïque avec des bus périphériques symétriques pour les bornes négative et positive selon l'art antérieur,
- la figure 2 représente une vue de dessous de la cellule photovoltaïque avec des bus périphériques asymétriques de longueurs différentes pour relier le collecteur frontal à la borne positive et le collecteur arrière à la borne négative, constitués d'une couche métallique déjà utilisée pour constituer le collecteur arrière selon la présente invention,
- les figures 3a, 3b, 3c, 3d représentent des coupes transversales des quatre étapes du procédé de réalisation de la cellule photovoltaïque selon une première forme d'exécution en gardant la zone de la couche conductrice d'électricité sans parties ajourées dans une zone centrale de lecture de la cellule photovoltaïque, mais en délimitant bien les zones positives des zones négatives,
- la figure 4 représente une vue de dessous de la cellule photovoltaïque avec des bus périphériques asymétriques donc de longueurs différentes par rapport au bus périphérique de la zone négative selon une première variante de réalisation de la présente invention représentée en coupe à la figure 3d,
- les figures 5a, 5b, 5c, 5d représentent des coupes transversales des quatre étapes du procédé de réalisation de la cellule photovoltaïque selon une seconde variante de réalisation de la cellule photovoltaïque, et
- les figures 6a, 6b, 6c, 6d représentent des coupes transversales des quatre étapes du procédé de réalisation de la cellule photovoltaïque selon une troisième variante de réalisation de la cellule photovoltaïque.

### Description détaillée de l'invention

Dans la description suivante, il est décrit principalement une cellule photovoltaïque mono segment disposant d'un agencement spécifique de collecteurs de courant comprenant des bus ou collecteurs périphériques asymétriques de manière à réduire la chute de tension entre au moins une borne positive et une borne négative de la cellule photovoltaïque.

La cellule photovoltaïque mono segment comprend principalement une première couche frontale transparente à la lumière ambiante, appelée collecteur frontal, qui peut être réalisée au moyen d'une couche d'oxyde de zinc dopée avec de l'aluminium (ZnO:AI ou AZO). Cette première couche peut être disposée sur la surface intérieure du verre de l'objet portable en regard d'un cadran et sur laquelle est généralement déposée une séquence de type p-i-n (dopage p, intrinsèque i, dopage n) de couches minces de silicium amorphe (a-Si), nommée absorbeur, qui produit des porteurs de charge électrique positive (trous) et négative (électrons) sous illumination. La structure se termine généralement par une deuxième couche conductrice, qui peut être une couche métallique par exemple en aluminium ou autre combinaison de métaux, appelée collecteur arrière.

La cellule photovoltaïque mono segment peut comprendre une couche de base sur laquelle elle est réalisée. L'une des faces du verre de l'objet portable, ou également une partie du cadran de l'objet portable peuvent servir de couche de base pour la cellule photovoltaïque. Dans la suite de la description, il sera donné préférence à la réalisation de la cellule photovoltaïque complète sur une face intérieure du verre.

On peut remarquer en comparaison à la figure 1 de l'art antérieur, qu'à la figure 2 il est montré une forme d'exécution relativement sommaire avec des bus périphériques ou collecteurs asymétriques permettant au bus périphérique positif 8'relié à des bornes définies positives 8'a et 8'b de fixer un potentiel quasi constant sur la plus grande portion de périphérie de la couche frontale de la cellule photovoltaïque à laquelle elle est reliée.

Cette modification visant à maintenir un potentiel quasi constant sur la plus grande portion de périphérie de la couche frontale de la cellule photovoltaïque permet de forcer la configuration quasi radiale des lignes de courant, comme montré sur la figure 2, et par là, de diminuer la différence de potentiel entre la valeur la plus haute au centre, et la plus basse en périphérie.

Le collecteur arrière relié à la borne définie négative 8 est constitué d'une couche métallique de faible résistivité électrique. Cela limite la différence de potentiel entre la borne 8 et son extrémité diamétrale à des valeurs négligeables en comparaison au collecteur frontal, malgré sa géométrie défavorable.

La cellule photovoltaïque 1 se présente sous la forme générale d'un cylindre de forme circulaire. Cette portion de cylindre peut être destinée à être fixée sous le verre de l'objet portable ou au-dessus du cadran de l'objet portable. Cet objet portable peut être par exemple une montre.

Dans cette configuration représentée à la figure 2, le bus périphérique positif 8' relié au collecteur frontal de la cellule photovoltaïque décrit une portion d'arc de cercle d'angle d'au moins 330°. Par contre, l'arc de cercle du bus périphérique négatif 8 décrit un angle de l'ordre de 30° ou inférieur. On peut même prévoir un arc de cercle de près de 350° pour le bus périphérique positif et moins de 10° pour le bus périphérique négatif 8.

Le bus périphérique positif 8' est relié sur une portion maximale de sa longueur, et de préférence sur toute sa longueur, au collecteur frontal non représenté sur cette figure 2. Cela signifie que ce bus périphérique positif se termine par une première borne positive 8'a et à l'opposé par une seconde borne positive 8'b, de manière à pouvoir les connecter, par la suite et par l'intermédiaire d'un connecteur spécifique, au module électronique disposé sous le cadran de l'objet portable. La borne négative du bus périphérique négatif sera également connectée au module électronique, par la suite et par le connecteur spécifique. Ces deux bornes positives 8'a et 8'b du bus périphérique positif 8' permettent de réduire de trois-quarts la chute de tension sur le bus périphérique positif par la mise en parallèle des deux secteurs de ce bus, en liaison au module électronique par la suite, en divisant par deux, d'une part le courant collecté, et d'autre part le chemin à parcourir.

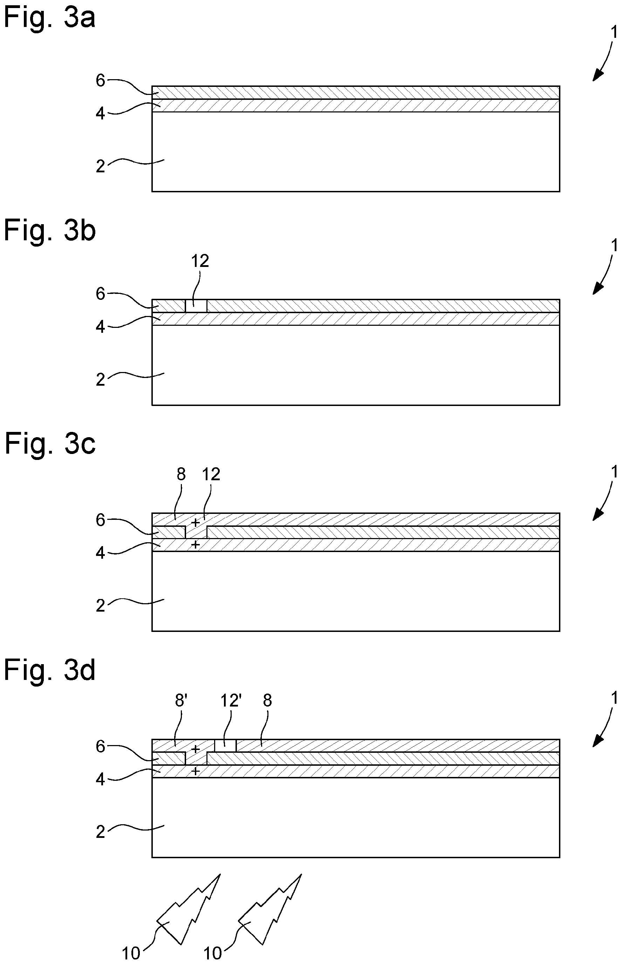

Les figures 3a, 3b, 3c, 3d montrent différentes étapes d'un procédé de réalisation d'une cellule photovoltaïque selon une première variante de réalisation. Comme on peut le remarquer sur la figure initiale 3a, il y a une couche de base 2, qui est une couche de verre, et qui fait partie de la cellule photovoltaïque en tant que telle dans ce cas de figure. Cependant il peut y avoir plusieurs couches les unes au-dessus des autres comme couche de base 2 et qui peuvent être constituées au moins d'une couche de verre sur ou sous laquelle sont placées une ou plusieurs couches d'un matériau transparent ou également au terme du procédé avec le dépôt d'une couche de saphir sur la couche de verre ou les couches de verre.

De manière plus générale, la cellule photovoltaïque 1 comprend comme couche de base, la première couche de collecteur frontal 4, qui est au terme du procédé de réalisation définie comme le collecteur frontal. Sur la première couche de collecteur frontal, il est déposé une séquence de type pi-n (dopage p, intrinsèque i, dopage n) de couches minces de silicium amorphe (a-Si), nommée absorbeur ou définie comme couche de silicium amorphe 6, et sur cette couche de silicium amorphe 6, il est encore ajouté une seconde couche conductrice 8, qui est de préférence une couche métallique telle qu'une couche en aluminium.

Toutes les étapes de réalisation et de structuration de la cellule photovoltaïque 1 sont décrites par la suite au moyen d'un verre 2 de l'objet portable agissant comme couche de base et sur laquelle sont réalisées et structurées les trois couches successives décrites ci-dessus à savoir la première couche de collecteur frontal 4, la couche de silicium amorphe 6, et la seconde couche conductrice 8.

Cela signifie que la cellule photovoltaïque 1 peut comprendre aussi bien la couche de verre 2 et les trois couches spécifiées ci-dessus ou uniquement les trois couches spécifiées ci-dessus.

Il est encore à noter que la cellule photovoltaïque 1 peut aussi être montée ou fixée sur un cadran de l'objet portable. Cependant dans ce cas de figure, c'est la couche du collecteur frontal 8, qui sert directement de couche de base, car au terme du procédé de réalisation de la cellule photovoltaïque 1 de type mono segment, cette dernière est montée ou fixée sur ledit cadran de l'objet portable du côté de la seconde couche conductrice (collecteur arrière), qui peut être une couche métallique. Cette première couche du collecteur frontal peut avantageusement être une couche d'oxyde de zinc ZnO ou une couche d'oxyde de zinc dopée avec de l'aluminium (ZnO:AI ou AZO).

Comme la couche de verre ou les couches de verre et de saphir sont généralement utilisées comme un verre de l'objet portable 2, les différentes étapes subséquentes sont effectuées sur une face intérieure du verre 2 de l'objet portable. La couche de verre 2 est représentée comme une couche de base sur laquelle sont déposées les différentes autres couches de la cellule photovoltaïque 1 mono segment.

À la figure 3a, on voit que sur une face de la couche de verre 2, il y a tout d'abord un dépôt d'une première couche de collecteur frontal 4, qui est faiblement conductrice d'électricité. Il peut s'agir d'une première couche frontale 4 qui est un oxyde de zinc ZnO ou une première couche d'oxyde de zinc dopée avec de l'aluminium (ZnO:AI ou AZO). Au-dessus de cette première couche frontale 4, il est prévu une séquence de type p-i-n (dopage p, intrinsèque i, dopage n) de couches minces de silicium amorphe (a-Si), nommée absorbeur placé ou déposé une couche de silicium amorphe 6 qui est utilisée pour capter les ondes électromagnétiques, c'est-à-dire la lumière par exemple afin de la convertir en énergie électrique à travers les couches disposées au-dessus et au-dessous de cette couche de silicium amorphe 6. La forme générale de la couche frontale 4 et de la couche de silicium amorphe 6 dépend principalement de la forme générale du verre sur lequel elles sont réalisées ou déposées. Principalement dans cette forme d'exécution présentée, la couche de base, qui est un verre 2 de l'objet portable, tel qu'une montre, peut être de forme générale circulaire en vue de dessus ou formant une portion de cloche de verre pour fermer la boîte de montre. Ainsi, la première couche frontale 4 prend une forme générale de cylindre circulaire de manière à être déposée ou fixée sur une face intérieure du verre 2 de montre. De même, la mince couche de silicium amorphe 6 est disposée ou déposée sur la première couche frontale 4 et de forme similaire à cette première couche frontale 4.

La seconde étape du procédé montrée à la figure 3b consiste à réaliser une ouverture 12 généralement en position périphérique de la cellule photovoltaïque 1 à travers la séquence de type p-i-n (dopage p, intrinsèque i, dopage n) de couches minces de silicium amorphe (a-Si), définie comme la couche 6 de silicium amorphe, montrant l'accès à la première couche frontale. Chaque ouverture 12 réalisée pour connecter la première couche de collecteur frontal peut être réalisée au moyen d'un laser ou d'une autre technique de gravure telle qu'utilisée en micro-électronique. Ensuite à la troisième étape du procédé de réalisation de la cellule photovoltaïque 1 montrée à la figure 3c, il est déposé une seconde couche conductrice 8 au-dessus de la couche de silicium amorphe 6. Cette seconde couche conductrice 8 est de préférence une couche métallique, telle qu'une couche d'aluminium. Cette couche métallique de préférence en aluminium passe à travers l'ouverture 12 réalisée à l'étape du procédé vue à la figure 3b, pour venir contacter la première couche frontale 4.

Finalement, la dernière étape du procédé de réalisation montrée à la figure 3d, consiste à effectuer une séparation de la seconde couche conductrice 8, qui peut être la couche métallique par exemple en aluminium 8, d'une part pour contacter la couche frontale TCO 4 et d'autre part de la couche métallique reliée aux parties d'au moins une borne négative de la cellule photovoltaïque. Pour ce faire il est réalisé à travers la couche conductrice d'électricité 8, une ouverture 12' dans la couche conductrice d'électricité, qui peut être une couche en aluminium 8 et formée de telle manière à faire la séparation de la couche métallique 8' en aluminium par exemple connectée à la première couche frontale 4, de la couche métallique 8 en aluminium connectée à la borne ou terminal négatif de la cellule photovoltaïque 1.

Au terme du procédé de cette première variante de réalisation de la cellule photovoltaïque 1 à la figure 3d, des faisceaux de lumière ou de la lumière 10 peuvent être captés par la cellule photovoltaïque 1. Il sera expliqué par la suite, que la cellule photovoltaïque 1 est destinée à être connectée à un module électronique généralement situé en dessous du cadran de l'objet portable pour effectuer la conversion de lumière en énergie électrique.

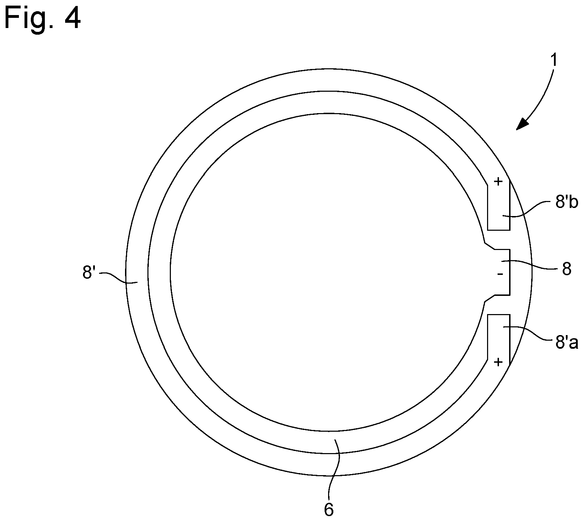

La figure 4 représente une vue depuis dessous au terme du procédé de réalisation pour montrer la séparation de la seconde couche métallique par exemple en aluminium pour relier d'une part la couche de collecteur frontal et d'autre part la borne négative de la cellule photovoltaïque 1. Sur cette figure 4, on peut bien remarquer la réalisation des bus périphériques asymétriques de la présente invention à savoir le bus périphérique positif relié à la couche de collecteur frontal, et le bus périphérique négatif relié à la borne de connexion négative de la cellule photovoltaïque.

La ou les ouvertures réalisées dans la seconde couche conductrice 8, telle que la couche en aluminium, permet de réaliser les bus périphériques positifs 8' pour la connexion par la suite à un module électronique en dessous du cadran de l'objet portable. Par la réalisation de ces ouvertures, on peut remarquer la couche de silicium amorphe 6 en dessous de cette couche conductrice qui est une couche en aluminium 8.

Chaque bus périphérique positif depuis la connexion avec la première couche de collecteur frontal se termine d'un premier côté par une première borne positive 8'a et d'un second côté par une seconde borne positive 8'b. Les deux secteurs de bus périphériques décrivent ensemble un arc de cercle total qui est défini sur 330° au moins. Le bus périphérique négatif de la couche d'aluminium n'est représenté que par la borne négative 8 qui est en regard des deux bornes positives 8'a et 8'b. Le bus périphérique négatif est d'un arc de cercle inférieur à 30°, ce qui montre l'asymétrie des bus périphériques positif et négatif, ce qui est recherché par la présente invention.

L'ensemble des deux secteurs de bus périphérique positif 8' est d'une longueur environ 10 fois supérieure à celle du bus périphérique négatif 8 ce qui apporte l'avantage de la réduction de chute de tension mentionnée plus haut, particulièrement aux plus fortes illuminations qui produisent un courant électrique plus important.

De plus dans cette première variante de réalisation la borne négative 8 est reliée directement au reste de la couche métallique 8 qui est sans parties ajourées et entourée par l'ensemble des deux secteurs de bus périphérique positif 8'.

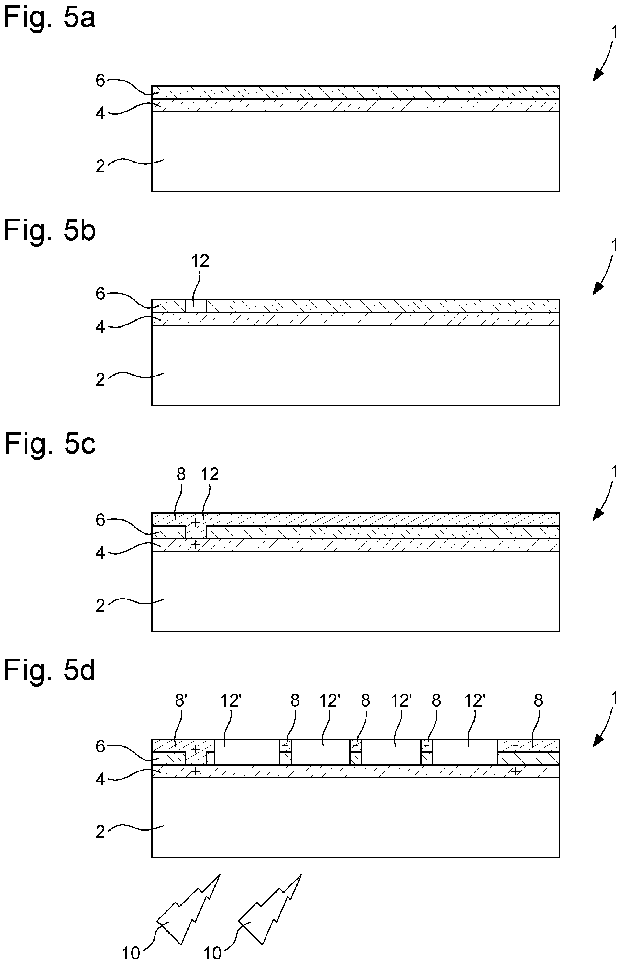

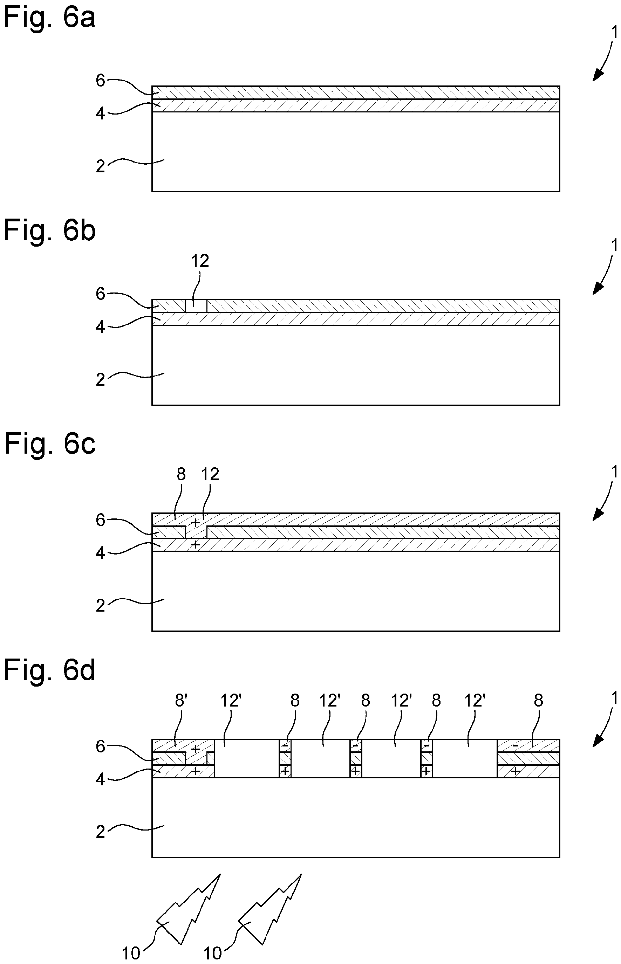

Les figures 5a, 5b, 5c, 5d représentent des coupes transversales des quatre étapes du procédé de réalisation de la cellule photovoltaïque selon une seconde variante de réalisation de la cellule photovoltaïque. Et les figures 6a, 6b, 6c, 6d représentent des coupes transversales des quatre étapes du procédé de réalisation de la cellule photovoltaïque selon une troisième variante de réalisation de la cellule photovoltaïque.

Il est à noter qu'il ne sera pas répété l'intégralité des étapes du procédé de réalisation de ces seconde et troisième variantes du procédé, car elles sont sensiblement similaires à celles décrites en référence aux figures 3a, 3b, 3c et 3d.

Pour la seconde variante de réalisation du procédé de réalisation de la cellule photovoltaïque 1, à la quatrième étape représentée à la figure 5d, une gravure chimique est effectuée pour attaquer aussi bien la couche conductrice 8, telle qu'une couche métallique 8, que la couche de silicium amorphe 6 pour obtenir les ouvertures référencées 12' définissant des parties ajourées.

De même pour la troisième variante de réalisation du procédé de réalisation de la cellule photovoltaïque 1, à la quatrième étape représentée à la figure 6d, une gravure chimique est effectuée pour attaquer aussi bien la couche conductrice 8, telle qu'une couche métallique 8, que la couche de silicium amorphe 6, et également la première couche frontale 4 au-dessus de la couche de base, qui peut être le verre 2 de l'objet portable.

Si des parties ajourées sont réalisées pour rendre la cellule photovoltaïque semi-transparente, il peut être prévu d'avoir un ajourage choisi entre 75 et 95 %, donc au maximum 25 % de couverture PV, ce qui devient trop visible, et au minimum 5 %, ce qui est difficile à concevoir, car la puissance de la cellule devient trop faible.

Cependant comme indiqué précédemment au début de la description détaillée, le procédé de réalisation de la cellule photovoltaïque peut débuter directement par une première couche de collecteur frontal 4 qui constitue une couche de base. Depuis cette couche de base, les autres couches sont disposées successivement depuis une face de cette première couche de collecteur frontal 4. Cette première couche de collecteur frontal 4 peut être avantageusement constituée d'une couche en oxyde de zinc ZnO ou première couche d'oxyde de zinc dopée avec de l'aluminium (ZnO:AI ou AZO).

Dans ce cas de figure décrit ci-dessus, la cellule photovoltaïque 1 réalisée n'est pas combinée avec un verre de l'objet portable ou directement sur le cadran de l'objet portable. Avec la cellule photovoltaïque 1 constituée uniquement des trois couches susmentionnées, il doit être prévu à la suite de pouvoir connecter les bornes de connexion du bus périphérique positif et du bus périphérique négatif à un module électronique disposé généralement en dessous du cadran de l'objet portable de manière à gérer les signaux reçus par l'intermédiaire de ses bornes de connexion des bus périphériques positif et négatif.

Il est à noter que pour la connexion de ces bornes de connexion des bus périphériques positif et négatif au module électronique de l'objet portable, il peut être prévu d'utiliser une liaison flexible de type FPC (flexible printed circuit) collé avec un film ACF (anisotropic conductive film), ou un connecteur à tiges ressort, appelées aussi pogo, ou encore un connecteur de type Zebra (bloc élastique contenant des zones conductrices régulièrement espacées). Cependant il ne sera pas décrit de manière plus détaillée la connexion de la cellule photovoltaïque au module électronique de l'objet portable, étant donné que la présente invention se base principalement sur la différence de longueur des bus périphériques positif et négatif de manière à optimiser le rendement d'une telle cellule photovoltaïque. Dans ce cas de figure grâce à l'agencement spécifique des bus périphériques positif et négatif, on constate une réduction de la chute de potentiel en liaison à la couche TCO à faible conductivité par rapport à ce qui est constaté dans les cellules photovoltaïques de l'état de l'art.

Différentes autres formes de la cellule photovoltaïque peuvent être envisagées par l'homme du métier sans sortir du cadre de l'invention définie par les revendications.

## Revendications

1. Cellule photovoltaïque (1) destinée à être disposée sur une surface intérieure d'un verre transparent ou sur un cadran d'un objet portable, ladite cellule photovoltaïque (1) comprenant une première couche conductrice transparente (TCO) constituant un collecteur frontal (4), une couche de silicium amorphe (6) sur la première couche de collecteur frontal (4) et une couche conductrice (8) sur la couche de silicium amorphe (6), constituant un collecteur arrière, une connexion électrique de la couche conductrice (8) à la première couche de collecteur frontal (4) étant réalisée à travers la couche de silicium amorphe (6), **caractérisée en ce que** la connexion électrique de la seconde couche conductrice (8) à la première couche de collecteur frontal (4) est réalisée à travers la couche de silicium amorphe (6) en périphérie de la cellule photovoltaïque, **en ce que** la couche conductrice (8) comprend un bus périphérique positif (8'), qui est relié à la première couche de collecteur frontal (4) et à au moins une borne de connexion positive (8'a, 8'b) à une extrémité du bus périphérique positif, et un bus périphérique négatif, qui est relié à une borne de connexion négative, et **en ce que** les bus périphériques positif et négatif sont asymétriques l'un par rapport à l'autre, avec le bus périphérique positif de plus grande longueur que le bus périphérique négatif.

2. Cellule photovoltaïque (1) selon la revendication 1, **caractérisée en ce que** l'épaisseur et la largeur du bus périphérique positif sont sensiblement identiques à l'épaisseur et à la largeur du bus périphérique négatif, et **en ce que** la longueur du bus périphérique positif est d'au moins plus de 10 fois supérieure à celle du bus périphérique négatif.

3. Cellule photovoltaïque (1) selon l'une des revendications précédentes, **caractérisée en ce que** la connexion électrique de la couche conductrice d'électricité (8) à la première couche TCO (4) est réalisée à travers la couche de silicium amorphe (6) sur la longueur totale du bus périphérique positif à réaliser dans la seconde couche conductrice (8) qui est une seconde couche métallique.

4. Cellule photovoltaïque (1) selon la revendication 3, **caractérisée en ce que** la couche métallique est une couche d'aluminium.

5. Cellule photovoltaïque (1) selon la revendication 3 pour laquelle la cellule photovoltaïque est de forme cylindrique circulaire en vue de dessus, **caractérisée en ce que** le bus périphérique positif décrit un arc de cercle total de 330° avec une connexion électrique périphérique à la première couche TCO (4) sur toute sa longueur, **en ce que** le bus périphérique positif se termine d'un premier côté par une première borne de connexion positive (8'a), et d'un second côté opposé par une seconde borne de connexion positive (8'b), et **en ce que** le bus périphérique négatif comprenant la borne de connexion négative est selon un arc de cercle inférieur à 30° avec de chaque côté la première borne de connexion positive (8'a) du bus périphérique positif et la deuxième borne de connexion positive (8'b) du bus périphérique positif.

6. Cellule photovoltaïque (1) selon la revendication 3 pour laquelle la cellule photovoltaïque est de forme cylindrique circulaire en vue de dessus, **caractérisée en ce que** le bus périphérique positif décrit un arc de cercle total de 350° avec une connexion électrique périphérique à la première couche TCO (4) sur toute sa longueur, **en ce que** le bus périphérique positif se termine d'un premier côté par une première borne de connexion positive (8'a), et d'un second côté opposé par une seconde borne de connexion positive (8'b), et **en ce que** le bus périphérique négatif comprenant la borne de connexion négative est selon un arc de cercle inférieur à 10° avec de chaque côté la première borne de connexion positive (8'a) du bus périphérique positif et la deuxième borne de connexion positive (8'b) du bus périphérique positif.

7. Cellule photovoltaïque (1) selon l'une des revendications précédentes, **caractérisée en ce que** les différentes couches successives depuis la première couche frontale TCO (4) sont réalisées sur une face intérieure du verre de l'objet portable, de manière à former un ensemble à cellule photovoltaïque mono segment avec le verre de l'objet portable (2) faisant partie de la cellule photovoltaïque.

8. Cellule photovoltaïque (1) selon l'une des revendications précédentes, **caractérisée en ce que** la couche conductrice (8) est une couche métallique, qui comprend dans une portion centrale reliée à la borne négative du bus périphérique négatif des parties ajourées de telle manière à rendre la cellule photovoltaïque semi-transparente.

9. Procédé de réalisation d'une cellule photovoltaïque (1) selon l'une des revendications 1 à 6, pour lequel le procédé comprend les étapes suivantes :
- déposer une couche de silicium amorphe (6) sur une première couche de type TCO (4),
- effectuer une ouverture (12) à travers la couche de silicium amorphe (6) pour donner accès à la première couche de type TCO (4),
- déposer une couche conductrice d'électricité (8) sur la couche de silicium amorphe (6), avec une partie de la couche conductrice d'électricité (8) venant contacter la première couche de type TCO (4),
le procédé **se caractérisant par** les étapes suivantes :
- réaliser l'ouverture à travers la couche de silicium amorphe (6) se situant dans une zone périphérique de la cellule photovoltaïque (1),
- effectuer une séparation de la couche conductrice d'électricité (8) d'une part pour contacter la couche frontale TCO (4) et réaliser le bus périphérique positif (8'), et d'autre part la couche métallique reliée aux parties du bus périphérique négatif lié à une borne négative (8) de la cellule photovoltaïque, en réalisant à travers la couche conductrice d'électricité (8), une ouverture (12') dans la couche conductrice d'électricité.

10. Procédé selon la revendication 9 pour lequel la couche conductrice d'électricité (8) est une couche métallique, telle qu'une couche d'aluminium.

11. Procédé selon l'une des revendications 9 et 10, pour lequel il est réalisé des parties ajourées dans une partie centrale de la couche métallique liée à la borne de connexion négative.

12. Procédé selon l'une des revendications 9 à 11, **caractérisée en ce que** toutes les étapes de réalisation de la cellule photovoltaïque (1) sont réalisées sur une couche de base qui est le verre (2) de l'objet portable faisant partie de la cellule photovoltaïque.
